# EUROPEAN PATENT APPLICATION

(11) **EP 4 277 444 A1**
(43) Date of publication of application: **15.11.2023**
(21) Application number: 22736811.5
(22) Date of filing: 04.01.2022
(51) Int. Cl.: H05K 7/20, H02M 7/00

(54) **CONVERTER**

(30) Priority: 05.01.2021 KR 20210001038
(71) Applicant: LG Innotek Co., Ltd., Seoul 07796 (KR)
(72) Inventor: KIM, Ki Dong, Seoul 07796 (KR); KIM, Ui Jong, Seoul 07796 (KR); CHAE, Hyung Jun, Seoul 07796 (KR)
(74) Representative: DREISS Patentanwälte PartG mbB
(86) International application number: PCT/KR2022/000107
(87) International publication number: WO 2022/149834

(57) **Abstract**

A converter comprises: a housing comprising an internal space; a printed circuit board disposed inside the internal space; a first electronic component disposed on the upper surface of the printed circuit board; a second electronic component disposed on the lower surface of the printed circuit board; and a heat dissipation space disposed inside the housing, wherein the first electronic component is disposed so as to overlap the heat dissipation space in a first direction, and the second electronic component is disposed so as to overlap the heat dissipation space in a second direction perpendicular to the first direction.

## Description

### [Technical Field]

The present embodiment relates to a converter.

### [Background Art]

Engine electrical devices (starting devices, ignition devices, and charging devices) and lighting devices are common as automobile electrical devices, but recently, most systems, including chassis electrical devices, are becoming electrically electronic as vehicles become more electronically controlled.

Various electrical components such as lamps, audio systems, heaters, and air conditioners installed in automobiles are designed to receive power from the battery when the car is stopped and from the generator when driving, and at this time, the generation capacity of the 14V power system is used as a normal power supply voltage.

Recently, along with the development of the information technology industry, various new technologies (motor-type power steering, Internet, and the like) aimed to enhance the convenience of automobiles are being adopted by vehicles, and in the future, it is expected that the development of new technologies that can maximally utilize the current automotive systems will continue.

A hybrid electric vehicle (HEV), regardless of soft or hard type, is equipped with a DC-DC converter (Low Voltage DC-DC Converter) for supplying an electric load (12V). In addition, the DC-DC converter, which serves as a generator (alternator) of a general gasoline vehicle, supplies a voltage of 12V for an electric load by lowering the high voltage of a main battery (usually a high-voltage battery of 144V or more).

A DC-DC converter refers to an electronic circuit device that converts DC power of a certain voltage into DC power of another voltage, and is used in various fields such as television receivers and electrical components of automobiles.

The outer appearance of the converter may be formed by the housing. One or more electronic components for driving are disposed inside the housing. As an example of the electronic component, there is a printed circuit board on which pluralities of elements are mounted. Elements being disposed on a printed circuit board generate heat by being driven. The generated heat may cause an overload of each electronic component, causing a trouble in a predetermined function and a failure. Accordingly, a structure or means for dissipating heat from components inside the converter is required.

### [Detailed Description of the Invention]

### [Technical Subject]

The present invention has been proposed to improve the above problems, and to provide a converter capable of improving heat dissipation efficiency by improving the structure.

### [Technical Solution]

A converter according to the present embodiment comprises: a housing including an internal space; a printed circuit board being disposed inside the internal space; a first electronic component being disposed on an upper surface of the printed circuit board; a second electronic component disposed on a lower surface of the printed circuit board; and a heat dissipation space being disposed in the housing, wherein the first electronic component is disposed to be overlapped with the heat dissipation space in a first direction, and wherein the second electronic component is disposed to be overlapped with the heat dissipation space in a second direction perpendicular to the first direction.

The first direction is an up and down direction, and the second direction may be a direction parallel to the printed circuit board.

A first heat conduction layer may be disposed between an upper surface of the heat dissipation space and a lower surface of the printed circuit board.

A groove being formed to be more recessed than other regions for accommodating the second electronic component may be disposed on a bottom surface of the internal space.

A second heat conduction layer may be disposed between an inner surface of the groove and an outer surface of the second electronic component.

The second heat conduction layer may include: a side surface portion being disposed between a side surface of the second electronic component and an inner surface of the groove; and a lower surface portion being disposed between the lower surface of the second electronic component and the bottom surface of the groove.

It may include a refrigerant pipe being disposed inside the heat dissipation space and in which a refrigerant flows.

The refrigerant pipe may comprise: a first straight portion having a refrigerant inlet part being disposed at one end; a second straight portion having a refrigerant discharge part being disposed at one end and parallel to the first straight portion; and a connection portion connecting the first straight portion and the second straight portion and perpendicular to the first straight portion and the second straight portion.

The second electronic component may be provided in plurality, and some of them are disposed along a first row parallel to the first straight portion, and some of the remaining ones may be disposed along a second row parallel to the second straight portion.

A converter according to another embodiment comprises: a printed circuit board; a first electronic component being disposed on an upper surface of the printed circuit board; a second electronic component being disposed on a lower surface of the printed circuit board; and a refrigerant pipe being disposed spaced apart from the lower surface of the printed circuit board, wherein the refrigerant pipe includes a first straight portion, a second straight portion parallel to the first straight portion, and a connection portion connecting the first straight portion and the second straight portion, wherein the first electronic component is disposed to be overlapped with the first straight portion, the second straight portion, and the connection portion in a direction perpendicular to the printed circuit board, and wherein the second electronic component is disposed between the first straight portion and the second straight portion.

### [Advantageous Effects]

Through the present embodiment, since the first electronic component and the second electronic component being disposed on both surfaces of the printed circuit board form an optimal heat dissipation structure with the refrigerant pipe, there is an advantage in that heat dissipation efficiency can be enhanced.

In particular, in the case of the second electronic component, since heat is dissipated not only from the lower surface but also from the side surface, there is an advantage in that the heat dissipation area of the electronic component can be increased.

### [Brief Description of Drawings]

FIG. 1 is a perspective view illustrating the outer appearance of a converter according to an embodiment of the present invention.
FIG. 2 is a plan view illustrating a lower surface of a converter according to an embodiment of the present invention.
FIG. 3 is a plan view illustrating an upper surface of a converter according to an embodiment of the present invention.
FIG. 4 is an exploded perspective view of a converter according to an embodiment of the present invention.
FIG. 5 is a plan view illustrating an upper surface of a converter without a cover and a printed circuit board according to an embodiment of the present invention.
FIG. 6 is a plan view illustrating an upper surface of a converter without a cover according to an embodiment of the present invention.
FIG. 7 is a plan view illustrating a lower surface of a printed circuit board according to an embodiment of the present invention.
FIG. 8 is a cross-sectional view of a heat dissipation structure in a converter according to an embodiment of the present invention.
FIG. 9 is a cross-sectional view taken along line A-A' of FIG. 3.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

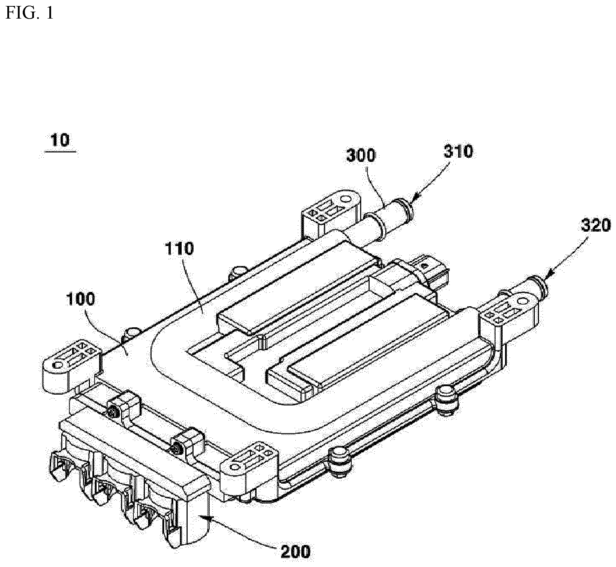

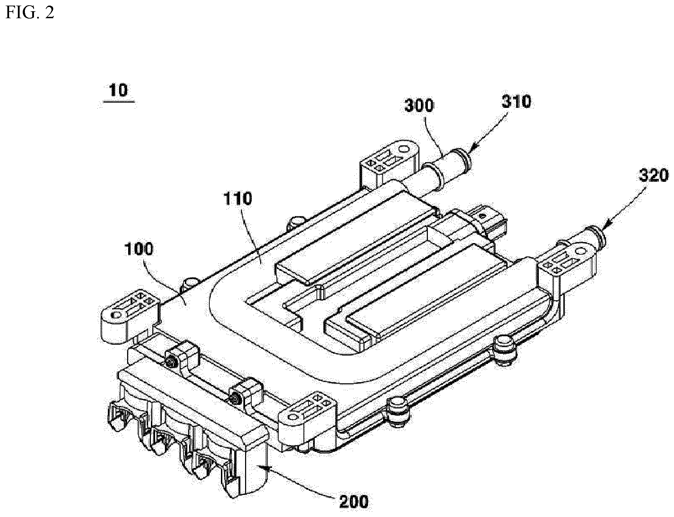

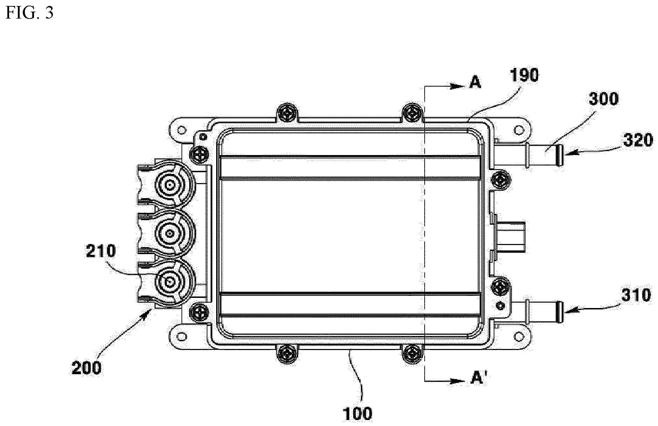

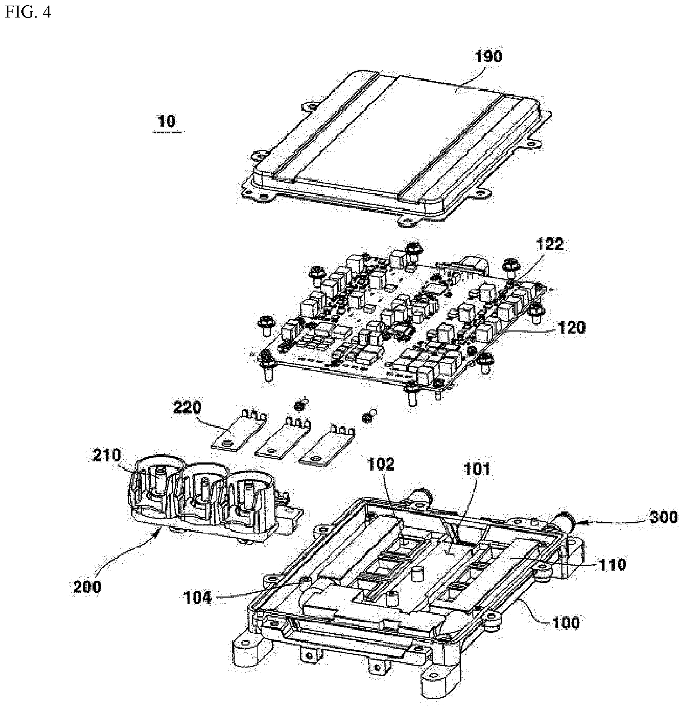

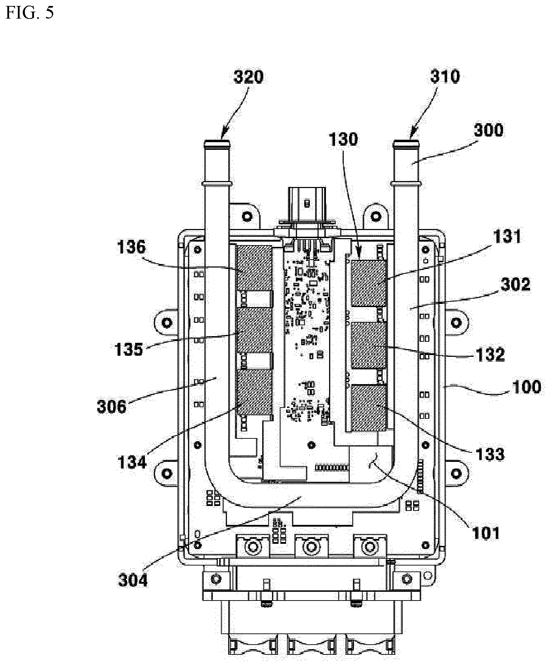

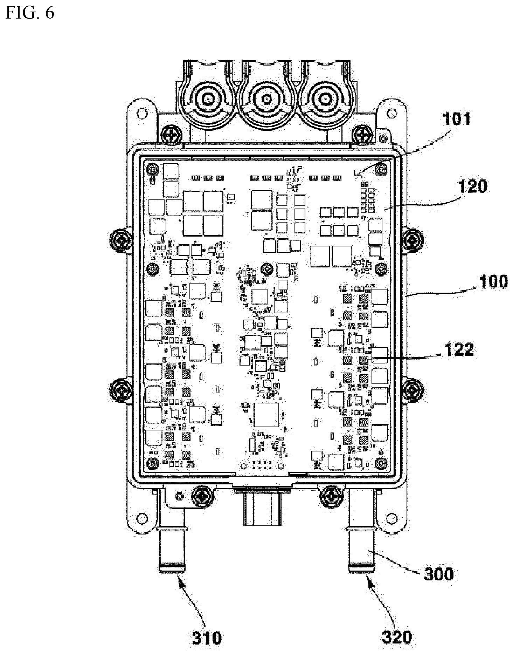

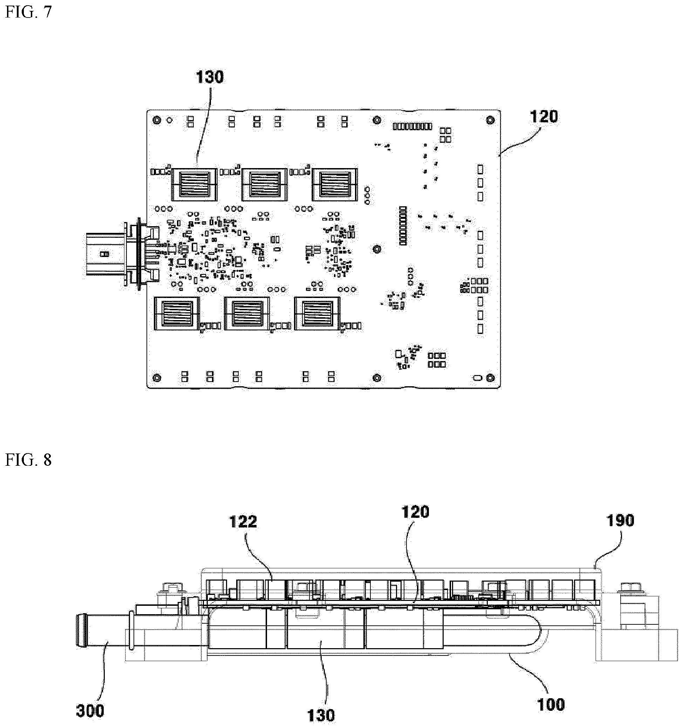

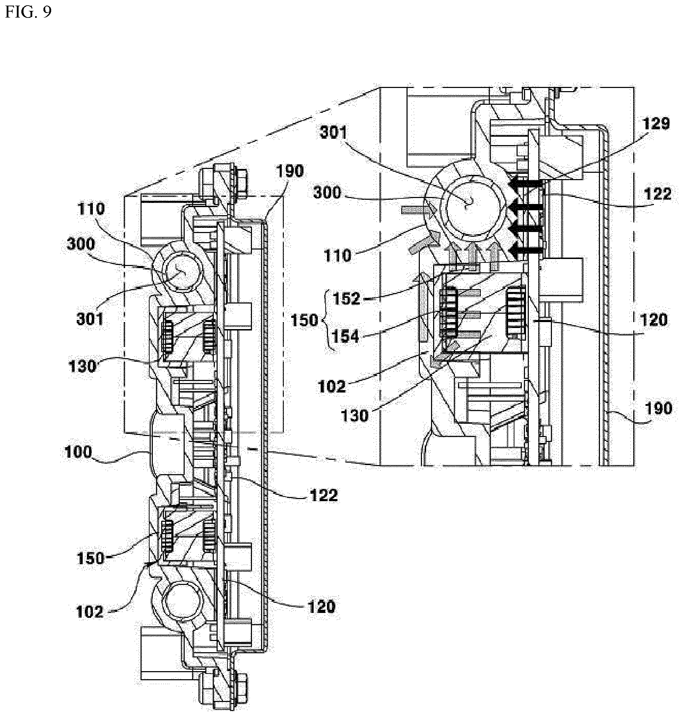

FIG. 1 is a perspective view illustrating the outer appearance of a converter according to an embodiment of the present invention; FIG. 2 is a plan view illustrating a lower surface of a converter according to an embodiment of the present invention; FIG. 3 is a plan view illustrating an upper surface of a converter according to an embodiment of the present invention; FIG. 4 is an exploded perspective view of a converter according to an embodiment of the present invention; FIG. 5 is a plan view illustrating an upper surface of a converter without a cover and a printed circuit board according to an embodiment of the present invention; FIG. 6 is a plan view illustrating an upper surface of a converter without a cover according to an embodiment of the present invention; FIG. 7 is a plan view illustrating a lower surface of a printed circuit board according to an embodiment of the present invention; FIG. 8 is a cross-sectional view of a heat dissipation structure in a converter according to an embodiment of the present invention; and FIG. 9 is a cross-sectional view taken along line A-A' of FIG. 3.

Referring to FIGS. 1 to 9, the outer appearance of the converter **10** according to an embodiment of the present invention may be formed by the housing **100.** An internal space **101** may be formed inside the housing **100** so that components for driving the converter **10** are disposed. A cover **190** is coupled to an upper surface of the housing **100** and may cover the upper surface of the internal space **101.** Screw holes are formed in the housing **100** and the cover **190** to allow screws to penetrate through regions corresponding to each other, and the housing **100** and the cover **190** can be screw-coupled together. A sealing member for sealing the internal space **101** may be disposed between the housing **100** and the cover **190.**

A connector module **200** may be disposed on a side surface of the housing **100.** The connector module **200** is disposed on a side surface of the housing **100** and may be exposed to the outside. At least a portion of the connector module **200** is disposed inside the housing **100** and may be electrically connected to a printed circuit board **120,** which will be described later.

The connector module **200** electrically connects the converter **10** and a battery (not shown) and the converter **10** and a load, and power provided from the battery may be converted in the converter **10.** The converted power may be applied to the load. For example, the high voltage power applied from the battery may be converted in the converter **10** and a low voltage power may be applied to the load. Therefore, a configuration for applying a power to the converter **10** through the connector module **200** or a configuration for receiving a power from the converter **10** can be connected.

However, this is exemplary, and the connector module **200** may be defined as including all configurations being disposed on an outer surface of the housing **10** in order to electrically and physically connect external terminals related to driving of the converter **10.**

The connector module **200** may include a bracket, a pin **210** being accommodated in the bracket, and a bus bar **220** electrically connecting the pin **210** and the printed circuit board **120.**

The converter **10** may include a refrigerant pipe **300.** The refrigerant pipe **300** may be coupled to the housing **100.** A heat dissipation space **110** may be formed inside the housing **100** to accommodate the refrigerant pipe **300.** At least a portion of the refrigerant pipe **300** may be disposed inside the heat dissipation space **110** and the other portion is protruded outward from the heat dissipation space **110** to be exposed to the outside. Among the lower surfaces of the housing **100,** a region where the heat dissipation space **110** is disposed may be protruded more downward than other regions. Among the spaces inside the housing **100,** the arrangement region of the heat dissipation space **110** may be partitioned from other regions. For example, the heat dissipation space **110** inside the housing **100** may have a partition wall shape surrounding the refrigerant pipe **300.**

The refrigerant pipe **300** has a flow path **301** so that the refrigerant flows therein, and a refrigerant inlet part **310** for introducing the refrigerant into the flow path **301** is disposed at one end, and the flow path **301** is disposed at the other end. A refrigerant discharge part **320** through which the refrigerant that has been circulated is discharged is disposed. The refrigerant pipe **300** may be formed in a pipe shape made of a metal material. Heat is exchanged by the refrigerant circulated along the flow path **301** so that the converter **10** can dissipate heat.

The refrigerant pipe **300** and the housing **100** may be integrally formed by gravity casting.

The refrigerant pipe **300** may include: a first straight portion **302** and a second straight portion **306** being disposed parallel to each other; and a connection portion **304** connecting the first straight portion **302** and the second straight portion **306.** The connection portion **304** may be disposed perpendicular to the first straight portion **302** and the second straight portion **304.** The connection region between the connection portion **304** and the first straight portion **302** and the connection region between the connection portion **304** and the second straight portion **306** may have a bent shape. The refrigerant inlet part **310** may be disposed at one end of the first straight portion **302,** and the refrigerant discharge part **320** may be disposed at one end of the second straight portion **306.**

The partition wall of the heat dissipation space **110** is formed to surround the first straight portion **302,** the second straight portion **306,** and the connection portion **304** being disposed inside the housing **100;** and the connection region between the first straight portion **302** and the connection portion **304,** and the connection region between the second straight portion **306** and the connection portion **304** may be exposed to the space inside the housing **100.**

At least one electronic component for driving the converter **10** may be disposed in the internal space **101.** The electronic component may include a printed circuit board **120,** a first electronic component **122,** and a second electronic component **130.**

The printed circuit board **120** is formed in a plate shape and may be disposed inside the internal space **101.** An upper surface of the printed circuit board **120** is disposed to face the cover **190** and a lower surface of the printed circuit board **120** may be disposed to face a bottom surface of the internal space **101.** A plurality of electronic components may be disposed on both surfaces of the printed circuit board **120.** The first electronic component **122** is disposed on an upper surface of the printed circuit board **120,** and the second electronic component **130** may be disposed on a lower surface of the printed circuit board **120.**

The first electronic component **122** may be disposed on an upper surface of the printed circuit board **120.** The first electronic component **122** may include an FET device. The first electronic component **122** is provided in plurality and may be mounted on the printed circuit board **120.** The plurality of first electronic components **122** may be disposed in a plurality of groups by forming a group of four. The four first electronic components **122** in a single group may be respectively disposed in corner regions. Each group may be spaced apart from each other.

The first electronic component **122** may be disposed to be overlapped with the refrigerant pipe **300** in an up and down direction (first direction). The first electronic component **122** may be disposed to be overlapped with the first straight portion **302** and the second straight portion **306** in an up and down direction. For example, the first electronic component **122** includes six groups, and the three groups overlap the first straight portion **302** in an up and down direction, and the remaining three groups may be disposed to be overlapped with the second straight portion **306** in an up and down direction.

The lower surface of the printed circuit board **120** may be in contact with an outer surface of the heat dissipation space **110.** A first heat conduction layer **129** may be disposed between the lower surface of the printed circuit board **120** and the upper surface of the heat dissipation space **110.** Under the interposition of the first heat conduction layer **129,** a lower surface of the printed circuit board **120** and an upper surface of the heat dissipation space **110** may be in contact with each other. The first heat conduction layer **129** is formed of a material having excellent thermal conductivity, and can transfer driving heat of the first electronic component **122** to the heat dissipation space **110.** An upper surface of the heat dissipation space **110** on which the first heat conduction layer **129** is disposed may be a flat surface.

The second electronic component **130** may be disposed on a lower surface of the printed circuit board **120.** The second electronic component **130** may include an inductor for obtaining inductance. The second electronic component **130** is provided in plurality and may be mounted on a lower surface of the printed circuit board **120.** Three of the second electronic components **130** forms one row and six of them may be disposed inside the internal space **101.** The six of the second electronic components **130** may include: a first row being formed by a second-first electronic component **131,** a second-second electronic component **132,** and a second-third electronic component **133;** and a second row being formed by a second-fourth electronic component **134,** a second-fifth electronic component **135,** and a second-sixth electronic component **136.** Each of the second electronic components **130** may be disposed to be spaced apart from one another.

A groove **102** to which the second electronic component **130** is coupled may be formed on a bottom surface of the internal space **101.** The groove **102** is formed to correspond to the cross-sectional shape of the second electronic component **130,** and a portion of the bottom surface of the internal space **101** may be recessed more downward than other regions. A portion of the second electronic component **130** may be accommodated inside the groove **102** and another portion thereof may be protruded outward from the groove **102.** An upper region of the second electronic component **130** being protruded out of the groove **102** may be coupled to the printed circuit board **120.** Of the lower surface of the housing **100,** a protrusion **107** being protruded more downward than other regions may be disposed in a region corresponding to the region where the groove **102** is formed. The protrusion **107** may be disposed to be overlapped with a region of the heat dissipation space **110** protruded to a lower surface of the housing **100** in a horizontal direction.

The second electronic component **130** may include a core and a coil being disposed inside the core. The core is disposed in the groove **102,** and the coil is exposed upward of the core to be electrically connected to the printed circuit board **120.**

At least a portion of the second electronic component **130** is disposed to be overlapped with the refrigerant pipe **300** in a horizontal direction. The horizontal direction (second direction) may be understood as a direction perpendicular to an up and down direction and a direction parallel to the printed circuit board **120.** The second-first electronic component **131,** the second-second electronic component **132,** and the second-third electronic component **133** may be disposed to be overlapped with the first straight portion **302** in a horizontal direction. The second-fourth electronic component **134,** the second-fifth electronic component **135,** and the second-sixth electronic component **136** may be disposed to be overlapped with the second straight portion **306** in a horizontal direction. Accordingly, driving heat of the second electronic component **130** can be easily transferred to the refrigerant pipe **300.**

Meanwhile, a second heating layer **150** may be disposed between the inner surface of the groove **102** and the outer surface of the second electronic component **130.** The second heat conduction layer **150** may include a side surface portion **152** being disposed between the side surface of the second electronic component **130** and the inner surface of the groove **102,** and a lower surface portion **154** being disposed between the lower surface of the second electronic component **130** and the bottom surface of the groove **102.** The cross section of the second heat conduction layer **150** may have the shape of a letter "⊏" by the side surface portion **152** and the lower surface portion **154.** The second heat conduction layer **150** is formed of a material having excellent thermal conductivity, and can transfer driving heat of the second electronic component **130** to the refrigerant pipe **300** and the heat dissipation space **110.** The second heat conduction layer **150** may have the shape of a pad.

According to the structure as described above, since the first electronic component and the second electronic component being disposed on both sides of the printed circuit board form an optimal heat dissipation structure with the refrigerant pipe, there is an advantage in that heat dissipation efficiency can be enhanced.

In particular, in the case of the second electronic component, since heat is dissipated not only from the lower surface but also from the side surface, there is an advantage in that the heat dissipation area of the electronic component can be increased.

In the above description, it is described that all the components constituting the embodiments of the present invention are combined or operated in one, but the present invention is not necessarily limited to these embodiments. In other words, within the scope of the present invention, all of the components may be selectively operated in combination with one or more. In addition, the terms "comprise", "include" or "having" described above mean that the corresponding component may be inherent unless specifically stated otherwise, and thus it should be construed that it does not exclude other components, but further include other components instead. All terms, including technical and scientific terms, have the same meaning as commonly understood by one of ordinary skill in the art unless otherwise defined. Terms used generally, such as terms defined in a dictionary, should be interpreted to coincide with the contextual meaning of the related art, and shall not be interpreted in an ideal or excessively formal sense unless explicitly defined in the present invention.

The above description is merely illustrative of the technical idea of the present invention, and those skilled in the art to which the present invention pertains may make various modifications and changes without departing from the essential characteristics of the present invention. Therefore, the embodiments disclosed in the present invention are not intended to limit the technical idea of the present invention but to describe the present invention, and the scope of the technical idea of the present invention is not limited by these embodiments. The protection scope of the present invention should be interpreted by the following claims, and all technical ideas within the equivalent scope should be interpreted as being included in the scope of the present invention.

## Claims

1. A converter comprising:
a housing including an internal space;
a printed circuit board being disposed inside the internal space;
a first electronic component being disposed on an upper surface of the printed circuit board;
a second electronic component disposed on a lower surface of the printed circuit board; and
a heat dissipation space being disposed in the housing,
wherein the first electronic component is disposed to be overlapped with the heat dissipation space in a first direction, and
wherein the second electronic component is disposed to be overlapped with the heat dissipation space in a second direction perpendicular to the first direction.

2. The converter according to claim 1,
wherein the first direction is an up and down direction, and
wherein the second direction is a direction parallel to the printed circuit board.

3. The converter according to claim 1,
wherein a first heat conduction layer is disposed between an upper surface of the

4. The converter according to any one claim among claims 1 to 3,
wherein a groove being formed to be more recessed than other regions and accommodating the second electronic component is disposed on a bottom surface of the internal space.

5. The converter according to claim 4,
wherein a second heat conduction layer is disposed between an inner surface of the groove and an outer surface of the second electronic component.

6. The converter according to claim 5,
wherein the second heat conduction layer include a side surface portion being disposed between a side surface of the second electronic component and an inner surface of the groove, and a lower surface portion being disposed between the lower surface of the second electronic component and the bottom surface of the groove

7. The converter according to any one claim among claims 1 to 3, including:
a refrigerant pipe being disposed inside the heat dissipation space and in which a refrigerant flows

8. The converter according to claim 7
wherein the refrigerant pipe comprises a first straight portion having a refrigerant inlet part being disposed at one end, a second straight portion having a refrigerant discharge part being disposed at one end and parallel to the first straight portion, and a connection portion connecting the first straight portion and the second straight portion and perpendicular to the first straight portion and the second straight portion.

9. The converter according to claim 8,
wherein the second electronic component is provided in plurality and some of them are disposed along a first row parallel to the first straight portion, and some of the remaining ones are disposed along a second row parallel to the second straight portion.

10. A converter comprising:
a printed circuit board;
a first electronic component being disposed on an upper surface of the printed circuit board;
a second electronic component being disposed on a lower surface of the printed circuit board; and
a refrigerant pipe being disposed spaced apart from the lower surface of the printed circuit board,
wherein the refrigerant pipe includes a first straight portion, a second straight portion parallel to the first straight portion, and a connection portion connecting the first straight portion and the second straight portion,
wherein the first electronic component is disposed to be overlapped with the first straight portion, the second straight portion, and the connection portion in a direction perpendicular to the printed circuit board, and
wherein the second electronic component is disposed between the first straight portion and the second straight portion.
